**Europäisches Patentamt**

**European Patent Office**

**Office européen des brevets**

(11) Publication number : **0 243 936 B1**

# EUROPEAN PATENT SPECIFICATION

(45) Date of publication of patent specification :
**11.03.92 Bulletin 92/11**

(51) Int. Cl.⁵ : **G03F 7/027,** G03F 3/10

(21) Application number : **87106150.3**

(22) Date of filing : **28.04.87**

(54) **Photopolymer color-proofing films with improved white light stability.**

(30) Priority : **30.04.86 US 857314**

(43) Date of publication of application :
**04.11.87 Bulletin 87/45**

(45) Publication of the grant of the patent :
**11.03.92 Bulletin 92/11**

(84) Designated Contracting States :
**BE DE FR GB**

(56) References cited :
**EP-A- 0 115 354**
**US-A- 3 432 578**
**US-A- 4 298 678**
**"Polymer degradation and stabilization", W.**
**Lincoln Hawkins, Spinger-Verlag 1984"**

(73) Proprietor : **E.I. DU PONT DE NEMOURS AND**
**COMPANY**
**1007 Market Street**
**Wilmington Delaware 19898 (US)**

(72) Inventor : **Koenigkramer, Rusty Eugene**
**American HoechstComp.**
**Enko Printing Products P.O.Box 3700**
**Somerville New Jersey 08876 (US)**

(74) Representative : **Werner, Hans-Karsten, Dr. et**
**al**
**Deichmannhaus am Hauptbahnhof**
**W-5000 Köln 1 (DE)**

## Description

FIELD

This invention relates to photopolymer color-proofing films which have improved stability to white light. In particular the invention provides a film containing hydroxylamine compounds for improved stability.

BACKGROUND

Photopolymer compositions, films and processes for making color proofs are disclosed in Chu et al. U.S. Patent 3,649,268 and Cohen et al. U.S. Patent 4,174,216, both incorporated herein by reference. The photopolymer compositions include a polymeric binder, an ethylenically unsaturated photopolymerizable monomer, and a photopolymerization initiator. The films of the Chu et al. patent are positive-working films and are composed of a photopolymer layer between a support sheet and a coversheet. Films of the Cohen et al. patent can be positive-working but preferred films are negative working. The Cohen et al. films are composed of a coversheet, photopolymer layer, a contiguous tonable elastomeric layer and, optionally, a support sheet.

Films of both types are used extensively in the graphic arts industry for making color proofs of the surprint type. Films of the Cohen et al. patent are also used for making proofs of the overlay type.

In making a surprint proof a piece of the film is laminated to color proofing paper and imagewise exposed through a coversheet and color separation transparency with ultraviolet radiation to create an image of exposed, polymerized areas and unexposed areas. The coversheet is removed and the image is developed by toning with toner of corresponding color. Another piece of film is laminated to the toned layer. Exposure, coversheet removal and toning are repeated, using a different color separation transparency and corresponding color toner. This process is repeated until the desired number of layers, usually four, are built up. The proof is examined for color balance under white lights, called 5000 Kelvin lights, which produce a significant amount of ultraviolet light.

This invention deals with a problem which arises in handling the film prior to toning, namely premature, blanket exposure and partial polymerization by the small ultraviolet component of room lights (usually fluorescent) and by stray ultraviolet light from the high energy exposure device and the 5000 Kelvin lights.

As a consequence of being preexposed with undesired and variable amounts of stray and ambient ultraviolet radiation, films fail to give expected results when they are imagewise exposed and toned to produce a surprint. A serious defect from the undesired effect of stray and ambient ultraviolet radiation is the inability to "hold" dot range, i.e., to reproduce dots ranging in size from small dots in 2% solid areas to large dots in 98% solid areas. Dot size diminishes over the entire tonal range and dots can even be completely eliminated by what is believed to be prepolymerization which begins around the edge of the dot and eventually destroys the dot completely with too high preexposure. The effect on 2% dots is very significant to the visual inspection of the artwork. Other defects such as a false decrease in dot gain occur from this ultraviolet preexposure.Dot gain is an apparent increase in dot size compared to dots in the transparency due to optical effects in the proof. Dot gain in a proof is desirable, provided it is approximately equal to the combined mechanical dot gain which occurs in printing and apparent dot gain due to optical effects in the print, since the purpose of a proof is to simulate the results which will be obtained upon printing. Thus a false decrease in dot gain due to preexposure can create problems in proofing.

It is customary in a graphic arts studio to prepare several proofs on a single large piece of paper, e.g., 73.7 x 101.6 cm (29 x 40 inches). Several minutes are required to position the transparencies on the film. Thus, different areas of the film receive different amounts of preexposure, and results for the proofs are not uniform.

McKeever U.S. patent 4,298,678 discloses the use of diethylhydroxylamine and other hydroxylamines as thermal stabilizers in photopolymerizable compositions containing admixtures of photooxidants and leuco dyes. The color proofing films of this invention do not contain leuco dyes. It is believed that the prior art does not disclose the use of hydroxylamines for any purpose in films not containing leuco dyes.

Martin U.S. Patent 3,432,578 discloses stabilization of conjugated diene polymers by adding a small amount of a hydroxylamine in which the two amino hydrogens are substituted by aryl and aralkyl radicals. There is mentioned that stabilization of polymeric material is needed for a variety of reasons, such as, depressing the adverse effects of ultraviolet light or its equivalent and to minimize the effects of cross-linking or depolymerization and the attendant changes in physical properties such as reduction in flexibility or increase in brittleness. This reference is concerned with stabilizing a polymerized conjugated diene to minimize depolymerization caused by ultraviolet light.

EP-A-0 111 314 discloses storage stable photopolymerizable composition which incorporate aldehyde condensation resin precursor containing polymeric acid binder, monomer photoinitiator and diethylhydroxylamine.

In Polymers, Properties and Applications vol. 8, W. Lincoln Hawkins, Polymer Degradation and Stabilization it is reported that allegedly it is generally accepted that reaction involved in photooxidation are similar to those of thermal oxidation. Both are now believed to proceed by a free-radical, chain mechanism, but there are important differences between them. Thus, although there are some similarities between this different phenomenalogical reactions it can not predict it form the behaviour of a substance in one of the systems towards the other system.

This invention is an improved photopolymer color proofing film comprising a support layer and a photopolymerizable layer consisting essentially of polymeric binder, ethylenically unsaturated monomer, and photopolymerization initiator, characterized in that the film has improved white light stability due to presence in the photopolymerizable layer of a hydroxylamine compound. In preferred form the film is a positive surprint film in which the support is removable after exposure without disturbing the photopolymer layer.

The invention is also an improved process of making a surprint color proof which comprises:

(a) laminating to color-proofing paper a photopolymer film having a coversheet adhered to a photopolymerizable layer comprising binder, monomer and initiator;

(b) imagewise exposing the photopolymerizable layer to ultraviolet radiation through the coversheet and a color separation transparency to create an image of exposed, polymerized areas and unexposed areas;

(c) removing the coversheet and developing the image by applying a corresponding color toner; (d) removing excess toner, laminating another piece of film to the toned layer; and repeating steps (b)-(c) with a different color separation transparency and corresponding color toner; and (e) optionally repeating step

(d) until the desired number of layers are built up. The improvement comprises using a photopolymer film as defined above, whereby a proof with well defined 2% dots is obtained.

In preferred form, the improved process produces a positive surprint color proof by use of a film from which the coversheet is removable after step (b) without disturbing the photopolymer layer and by toning in step (c) the entire photopolymer layer whereby toner adheres selectively to unexposed areas.

## DETAILED DESCRIPTION

Hydroxylamine compounds which can be used in this invention include the ones disclosed in McKeever U.S. Patent 4,298,678. These are compounds of the formula $R_1R_2NOH$, and acid salts thereof, wherein each of $R_1$ and $R_2$ can be hydrogen with the proviso that both cannot be hydrogen, a linear or branched-chain alkyl group of 2 to 14 carbon atoms, a cyclic alkyl group of 5 to 14 carbon atoms, an aryl group of 6 to 10 carbon atoms, an aralkyl group wherein the aryl moiety is of 6 to 10 carbon atoms and the alkyl moiety is of 1 to 14 carbon atoms, and an alkaryl group wherein the aryl moiety is of 6 to 10 carbon atoms and the alkyl moiety is of 1 to 9 carbon atoms, and $R_1$ and $R_2$ when taken together may with the nitrogen atom form a heterocyclic ring of 5 to 7 carbon atoms.

Preferred hydroxylamines are N,N-diethylhydroxylamine, N,N-dibenzylhydroxylamine, N-cyclohexylhydroxylamine, N-hydroxypyridine and N-hydroxypiperidine.

The films exhibit improved stability to white light with as little as about 0.005 percent of hydroxylamine by weight, based on weight of the photopolymerizable layer. The film can tolerate about to 3 percent hydroxylamine without unacceptable loss of photospeed. Preferred are amounts in the range of about 0.05 to 0.5% by weight.

The binder, monomer and initiator components of the film can be any of the conventional organic polymeric binders, ethylenically unsaturated, free radical initiated, addition polymerizable monomers, and free radical generating photopolymerization initiators described in Chu et al. U.S. Patent 3,649,268 and Cohen et al. U.S. Patent 4,174,216, cited above, and in numerous other patents, including Burg et al. U.S. 3,060,023, Celeste et al. U.S. 3,261,686, Chambers U.S. 3,479,185, Chang et al. U.S. 3,549,367, Baum et al. U.S. 3,652,275, Crary U.S. 3,661,576, Cescon U.S. 3,784,557, Held U.S. 3,854,950, Dessauer U.S. 4,252,887, Chambers et al. U.S. 4,264,708 and Tanaka U.S. 4,459,349. The disclosures of all of these patents are incorporated herein by reference.

Preferred binders include polymethylmethacrylate homopolymers and copolymers with acrylic or methacrylic acid and mixtures thereof with polyvinyl acetate, and copolymers of methylmethacrylate/ethylacrylate acrylic acid, optionally crosslinked with zinc ions. The latter are especially preferred for use with epoxy acrylate monomers, as described below.

Preferred monomers are di-, tri- and tetraacrylates and -methacrylates such as trimethylolpropane triacrylate, ethoxylated trimethylolpropane triacrylate and epoxy acrylates. The latter are diacrylate and dimethacrylate esters of bisphenol A/epichlorohydrin epoxy resins. Their use in photopolymerizable compositions is disclosed in the Crary, Cohen et al. and Chambers et al. patents cited above. Their use in low dot gain photopolymer positive surprint color proofing is described in an application of assignee filed simultaneously herewith (Docket No. PD-2320). As described in that application, it is preferred to use the epoxy acrylates in combination with another acrylate or methacrylate which has a plasticizing action on the methylmethacrylate/ethylacrylate/acrylic acid binder.

Preferred initiators are the hexaarylbiimidazoles, especially 2,2'-bis(o-chlorophenyl)-4,4',5,5'-tetraphenylbiimidazole.

In addition to the binder, monomer and initiator, practical films of this invention will include conventional components such as chain transfer agents, UV absorbers, optical brighteners and thermal stabilizers and plasticizers, all as disclosed in the above cited patents and co-pending application. As described in the co-pending application a particularly preferred plasticizer for use with an epoxy acrylate and zinc crosslinked methylmethacrylate/ethylacrylate/acrylic acid is a mixture of trimethylolpropane and glycerol triacetate.

Proportions of ingredients can vary widely, but in general will fall in the following ranges of weight percent based on the total photopolymerizable layer: binder, 25 to 75%, preferably 35 to 50%, monomer, 10 to 60%, preferably 15 to 50%; initiator, 0.1 to 10%, preferably 1 to 5%, hydroxylamine, 0.005 to 3%, preferably 0.05 to 0.5%, plasticizer 0 to 50%, preferably 5 to 25%, and other components 0 to 5%, preferably 1 to 4%.

## EXAMPLES

The following examples illustrate the invention wherein the percentages are given by weight. In the following examples photosensitive compositions containing the ingredients set forth below are dissolved in methylene chloride at 15% solids. Samples are prepared to which are added the hydroxyamine compounds listed below. Films are cast from a 0.038 mm (0.0015 inch) coating knife onto 0.025 mm (0.001 inch) polyethylene terephthalate film giving a 0.0038 mn (0.00015 inch) coating. The solvent is removed by air drying.

This coating is laminated at about 110°C to the smooth side of Kromekote® cast-coated one-side paper, manufactured by Champion Paper and Fiber Company, using a Cromalin® Laminator Model 2700 manufactured by E. I. du Pont de Nemours and Company, Wilmington, DE. This element is then given a blanket exposure with no artwork present in a Montakop vacuum contact frame manufactured by Siegfried Theimer Gmbh, Bad Homburg, West Germany fitted with a 5 KW photopolymer lamp. After coversheet removal a second clear photopolymer layer is laminated onto the first layer at 110°C. A section of the photopolymerizable surface is covered with a rectangular, opaque mask and the masked, laminated sample is placed in a Prooflite® viewing booth Model CVB-1 under MacBeth 5000 Kelvin temperature lamps (described as F40T12/50 40W part# 20115020) manufactured by MacBeth a division of Kollmorgen Corp., Newburgh, NY. After uniformly exposing the masked sample for the indicated time, the mask is removed and a 150 lines/inch 50% halftone screen tint manufactured by Beta Screen Corp., Carlstadt, NJ is positioned such that half covered the exposed area and other half covered the unexposed area. The sample plus tint is placed in a Montakop vacuum contact frame manufactured by Siegfried Theimer Gmbn, Bad Homburg, West Germany and exposed with a 5 KW photopolymer lamp and Kokomo® glass filter (No. 400), manufactured by the Kokomo Opalescent Glass Co., Kokomo, Ind. and given a sharp exposure where 2% highlight dots are just held. After exposure the tint and polyethylene terephthalate film are removed. An Automatic Toning Machine Model 2900 manufactured by E. I. du Pont de Nemours and Company, Wilmington, DE is used to apply a magenta colorant material described in Example 11 of U.S. Patent 4,215,193 to the photopolymer surface.

A third clear photopolymer layer is laminated onto the toned second layer at 110°C. The three-layer element is then given a blanket exposure with no artwork present and the coversheet removed. Two additional layers are added in this same manner to simulate a traditional five layer proof.

The effective dot areas (EDA) of the toned tint in the finished proof over the white light exposed and the unexposed areas are measured using the green filter on a Macbeth RD-918 densitometer manufactured by Kollmorgen Corp., Newburgh, NY. As explained in the RD-918 manual (issue date 12-1980), the Murray-Davies equation (J. Franklin Inst., Vol. 221, pages 721-744, 1936) is used to calculate the effective dot area. The following results are obtained for the indicated compounds wherein the $\Delta$EDA equals the difference between EDA (unexposed) minus EDA (exposed).

Examples 1 to 11

| Ingredient | Amount (g) |
|---|---|
| Diacrylate ester of bisphenol A epoxy resin derived from bisphenol A and epichlorohydrin viscosity (25°C) = 1,000,000 cps | 36.10 |
| Optical brightener(1) | 3.20 |
| 2-Mercaptobenzoxazole | 1.63 |
| 2,2'-Bis-(o-Chlorophenyl)-4,4',5,5' tetraphenylbiimidazole | 1.46 |
| Trimethylolpropane | 4.93 |
| Glyceryl triacetate | 4.93 |
| Polyoxyethylene (3) trimethylolpropane | 4.93 |
| Ethyl acrylate(56%)/methylmethacrylate-(37%)/ acrylic acid(7%) copolymer MW = 260,000; Acid No. = 80; Tg = 35°C | 38.69 |
| Polyethylene oxide, MW = 300,000 | 1.21 |
| Zinc acetylacetonate (2.71 grams) dissolved in 37.0 grams of methanol | 39.71 |

(1) 7-(4'-Chloro-6'-diethylamino-1',3',5'-triazine-4'-yl) amino 3-phenyl coumarin

| Hydroxyamine Compound (g) | | Δ EDA (50% dot area) | | |
|---|---|---|---|---|
| | | 2 minutes | 4 minutes | 6 minutes |
| (1) | none | 4 | 42 | 65 |
| (2) | N,N-diethyl- | | | |
| | 0.005 | 4 | 20 | 22 |
| | 0.12 | 1 | 3 | 4 |
| | 1.00 | 0 | 2 | 2 |
| | 3.00 | 0 | 0 | 0 |
| (3) | N-cyclohexyl- | | | |
| | 0.12 | 2 | 2 | 3 |
| (4) | N,N-dibenzyl- | | | |
| | 0.12 | 0 | 2 | 5 |
| (5) | N-hydroxypiperidine | | | |
| | 0.12 | 1 | 4 | 6 |
| (6) | 2,3-bis(hydroxyamino) -2,3-dimethylbutane | | | |
| | 0.12 | 0 | 0 | 1 |
| (7) | N-tert-butyl- | | | |
| | 0.12 | 2 | 2 | 8 |
| (8) | N-cyclohexyl- x HCl | | | |
| | 0.12 | 1 | 5 | 10 |
| (9) | N-hydroxyphthalimide | | | |
| | 0.12 | 3 | 7 | 16 |
| (10) | N-hydroxymaleimide | | | |
| | 0.12 | 1 | 5 | 5 |
| (11) | 2,3-bis(hydroxyamino) -2,3-dimethylbutane x H2SO4 | 3 | 10 | 19 |

Examples 12 to 14

| Ingredient | Amount (g) |
|---|---|
| Polymethylmethacrylate, MW = 629,000 | 32.39 |
| Polyvinylacetate, MW = 120,000 | 12.64 |
| Trimethylolpropanetrimethacrylate | 35.35 |
| Polyoxyethylatedtrimethylolpropane-triacrylate, MW - 1162 | 7 29 |
| 2,2'-Bis-(o-Chlorophenyl)-4,4',5,5'-tetraphenylbiimidazole | 1.90 |
| Polyethylene (4) lauryl ether | 7.90 |
| 2-Mercaptobenzoxazole | 0.78 |
| Optical brightener[1] | 1.20 |
| Optical brightener[2] | 0.22 |
| 2,2'-dihydroxy-4-methoxybenzophenone | 0.08 |

(1) 7-(4'-Chloro-6'-diethylamino-1',3',5'-triazine-4'-yl) amino 3-phenyl coumarin
(2) 2-(Stilbyl-4")-naphtho-1',2',4,5)-1,2,3 triazole-2"-sulfonic acid phenyl ester

| Hydroxyamine Compound (g) | Δ EDA (50% dot area) | | |
|---|---|---|---|
| | 2 minutes | 4 minutes | 6 minutes |
| (12) none | 25 | 74 | 74 |
| (13) N-diethyl- | | | |
| (0.08) | 8 | 20 | 25 |
| (1.00) | 2 | 9 | 17 |
| (14) N-dibenzyl- | | | |
| (0.12) | 10 | 25 | 33 |

The best mode is illustrated below. The solution is prepared as above and the resulting film laminated to Kromekote®. A section of the photopolymerizable surface is covered witn a rectangular, opaque mask and the masked, laminated sample is placed in a Prooflite® viewing booth. After uniformly exposing the masked sample for the indicated time, the mask is removed and a 150 lines/inch 50% halftone screen tint is positioned such that half covered the exposed area and other half covered the unexposed area. The sample plus tint is placed in a vacuum contact frame and exposed with a 5 KW photopolymer lamp and Kokomo® glass filter (No. 400) and given a sharp exposure where 2% highlight dots are just held. After exposure, the tint and polyethylene terephthalate film is removed. An Automatic Toning Machine Model 2900 manufactured by E. I. du Pont de Nemours and Company, Wilmington, DE is used to apply a yellow colorant material described in Example 9 of U.S. Patent 4,215,193 to the photopolymer surface.

A second clear photopolymer layer is laminated onto the yellow toned first layer at 110°C. As outlined above the two-layer element is then masked, placed under the proof light for the indicated time, mask removed, 150 lines/inch 50% tint positioned such that half covered the exposed area and other half covered the unexposed area, given a sharp exposure, and the coversheet removed. To the photopolymer surface a magenta colorant material described in Example 11 of U.S. Patent 4,215,193 is applied. This procedure is repeated two more times toning the third layer with a cyan colorant material described in Example 1 of U.S. Patent 4,215,193 and the fourth layer witn a black colorant material described in Example 10 of U.S. Patent 4,215,193.

After application of the black toner, a fifth photopolymer element is laminated at 110°C over the four-color halftone positive. The five-layer element is given an overall blanket exposure under the above-described light source. Next, the polyethylene terephthalate coversheet is removed.

The effective dot areas (EDA) of the toned tint in the finished proof over the white light exposed and the unexposed areas are measured using a Macbeth RD-918 densitometer. The yellow, magenta, cyan, black tints are measured using a green, blue, red, and visual filters respectively. As explained above the Murray-Davies equation is used to calculate the effective dot area. The following results are obtained for the indicated colored toners wherein the ΔEDA equals the difference between EDA (unexposed) minus EDA (exposed).

Examples 15 to 18

| Ingredient | Amount (g) |
|---|---|
| Diacrylate ester of bisphenol A epoxy resin derived from bisphenol A and epichlorohydrin viscosity (25°C) = 1,000,000 cps | 18.48 |
| Trimethylolpropanetrimethacrylate | 13.66 |
| Optical brightener[1] | 2.06 |
| 2-Mercaptobenzoxazole | 0.83 |
| 2,2'-Bis-(o-Chlorophenyl)-4,4',5,5' tetraphenylbiimidazole | 1.71 |
| Trimethylolpropane | 5.08 |
| Glyceryl triacetate | 6.75 |
| Methoxyhydroquinone | 0.022 |
| Thermal inhibitor[2] | 0.05 |
| Diethylhydroxylamine | 0.09 |
| Ethyl acrylate(57%)/methylmethacrylate-(39%)/ acrylic acid(4%) copolymer MW = 192,000; Acid No. = 57; Tg = 33°C | 18.06 |
| Ethyl acrylate, Acid No. = 63; Tg = -14°C viscosity (25°C) = 2,000,000 cps; MW = 7,000 | 5.40 |
| Ethyl acrylate(17%)/methylmethacrylate-(71%)/acrylic acid(12%) copolymer MW = 200,000; Acid No. = 100; Tg = 80°C | 25.15 |
| Polycaprolactone MW = 15,000; M.P. = 60°C; Tg = -60°C | 0.20 |
| Zinc acetylacetonate (2.45 grams) dissolved in 37.0 grams of methanol | 39.45 |

(1) 7-(4'-Chloro-6'-diethylamino-1',3',5'-triazine-4'-yl)amino 3-phenyl coumarin
(2) 1,4,4-Trimethyl-2,3-diazabicyclo-[3.2.2]-non-2-ene-N,N-dioxide

| Hydroxyamine Compound (g) | Δ EDA (50% dot area) | | |
|---|---|---|---|
| | 2 minutes | 4 minutes | 6 minutes |
| (15) Yellow | 1 | 2 | 4 |
| (16) Magenta | 0 | 1 | 3 |
| (17) Cyan | 0 | 0 | 3 |
| (18) Black | 0 | 0 | 1 |

## Claims

1. A photopolymer color proofing film, devoid of leuco dye, comprising a support layer and a photopolymerizable layer consisting essentially of polymeric binder, ethylenically unsaturated monomer, and photoinitiator, characterized in that the film has improved white light stability due to presence in the photopolymerizable layer of a white-light stabilizing effective amount in the range of 0.005 to 3 % by weight of a hydroxylamine compound of the formula $R_1R_2NOH$, and acid salts thereof, wherein each of $R_1$ and $R_2$ can be hydrogen with the proviso that both cannot be hydrogen, a linear or branched-chain alkyl group of 2 to 14 carbon atoms a cyclic alkyl group of 5 to 14 carbon atoms, an aryl group of 6 to 10 carbon atoms, an aralkyl group wherein the aryl moiety is of 6 to 10 carbon atoms and the alkyl moiety is of 1 to 14 carbon atoms, and an alkaryl group wherein the aryl moiety is of 6 to 10 carbon atoms and the alkyl moiety is of 1 to 9 carbon atoms, and $R_1$ and $R_2$ when taken together may with the nitrogen atom form a heterocyclic ring of 5 to 7 carbon atoms.

2. Positive surprint film of claim 1 composed of a photopolymerizable layer between a support sheet and a cover sheet in which the support layer is removable after imagewise exposure and polymerization, without disturbing the photopolymer layer, the amount of hydroxylamine compound being in the range of 0.05 to 0.5 % by weight, based on the weight of the photopolymerizable layer.

3. Film of claim 2 wherein $R_1$ is alkyl of 2 to 14 carbon atoms, benzyl or cyclohexyl and $R_2$ is H or the same as $R_1$, or $R_1$ and $R_2$ together with the nitrogen form pyridine or piperidine.

4. Film of claim 2 wherein $R_1$ and $R_2$ are each ethyl or $R_1$ is cyclohexyl and $R_2$ is H.

5. Film of claim 3 wherein the monomer is a di-, tri- or tetra-acrylate or -methacrylate and the photoinitiator is a hexaarylbiimidazole.

6. Film of claim 4 wherein the binder component consists essentially of polymethylmethacrylate and polyvinylacetate, the monomer component consists essentially of trimethylolpropane trimethacrylate and ethoxylated trimethylolpropane triacrylate, and the photoinitiator component consists essentially of 2,2'-bis(o-chlorophenyl)-4,4',5,5'-tetraphenylbiimidazole and 2-mercaptobenzoxazole.

7. Film of claim 4 wherein the binder, monomer and photoinitiator components, respectively, consist essentially of: methylmethacrylate/ethyl acrylate/acrylic acid copolymers; trimethylolpropane trimethacrylate and diacrylate ester of bisphenol A/-epichlorohydrin epoxy resin; and 2,2'-bis(o-chlorophenyl)-4,4',5,5'-tetraphenylbiimidazole and 2-mercaptobenzoxazole.

8. A process of making a surprint color proof which comprises:

(a) laminating to color proofing paper a photopolymer film having a coversheet adhered to a photopolymerizable layer, devoid of leuco dye, comprising binder, monomer and initiator:

(b) imagewise exposing the photopolymerizable layer to ultraviolet radiation through the coversheet and a color separation transparency to create an image of exposed, polymerized areas and unexposed areas;

(c) removing the coversheet and developing the image by applying a corresponding toner;

(d) removing excess toner, laminating another piece of film to the toned layer and repeating steps (b)-(c) with a different color separation transparency and corresponding color toner; and

(e) optionally repeating step (d) until the desired number of layers are built up; characterized in that the film is stabilized against white light preexposure by inclusion in the photopolymerizable layer a white-light stabilizing effective amount in the range of 0,005% to 3.0 % by weight of a hydroxylamine compound of the formula: $R_1R_2NOH$ according to claim 1.

9. Process of claim 8 for producing a positive surprint color proof by using a film from which the coversheet is removable after step (b) without disturbing the photopolymer layer and by toning in step (c) the entire photopolymer layer whereby toner adheres selectively to unexposed areas

10. Process of claim 9 wherein multiple proofs are prepared on a single sheet of paper.

11. Process of claim 10 wherein the hydroxylamine compound is diethylhydroxyamine, N-cyclohexylhydroxylamine, N,N-dibenzylhydroxylamine, N-hydroxypyridine or N-hydroxypiperidine.

12. Process of claim 10 wherein the hydroxylamine compound is N,N-diethylhydroxylamine.

**Patentansprüche**

1. Photopolymer-Film für die Farbprüfung, ohne Leukofarbstoff, umfassend eine Trägerschicht und eine photopolymerisierbare Schicht, im wesentlichen bestehend aus polymerem Bindemittel, ethylenisch ungesättigtem Monomer und Photoinitiator, dadurch gekennzeichnet, daß der Film deswegen verbesserte Weißlichtstabilität besitzt, weil in der photopolymerisierbaren Schicht eine Weißlichtstabilisierende wirksame Menge im Bereich von 0,005 bis 3 Gew.-% einer Hydroxylamin-Verbindung der Formel $R_1R_2NOH$ und deren saurer Salze vorhanden ist, worin $R_1$ und $R_2$ jeweils Wasserstoff sein können, mit der Maßgabe, daß nicht beide Wasserstoff sein können, eine lineare oder verzweigte Alkyl-Gruppe mit 2 bis 14 KohlenstoffAtomen, eine cyclische Alkyl-Gruppe mit 5 bis 14 Kohlenstoff-Atomen, eine Aryl-Gruppe mit 6 bis 10 Kohlenstoff-Atomen, eine Arylalkyl-Gruppe, worin die Aryl-Einheit 6 bis 10 Kohlenstoff-Atome und die Alkyl-Einheit 1 bis 14 Kohlenstoff-Atome aufweist, und eine Alkylaryl-Gruppe, worin die Aryl-Einheit 6 bis 10 Kohlenstoff-Atome und die Alkyl-Einheit 1 bis 9 Kohlenstoff-Atome aufweist, und $R_1$ und $R_2$ zusammen mit dem Stickstoff-Atom einen heterocyclischen Ring mit 5 bis 7 Kohlenstoff-Atomen bilden können.

2. Positiver Aufdruckfilm nach Anspruch 1, zusammengesetzt aus einer photopolymerisierbaren Schicht zwischen einer Trägerlage und einer Decklage, wobei die Trägerschicht nach abbildweiser Belichtung und Polymerisation entfernt werden kann ohne die Photopolymer-Schicht zu beeinträchtigen, wobei die Menge an Hydroxylamin-Verbindung im Bereich von 0,05 bis 0,5 Gew.-% liegt, bezogen auf das Gewicht der photopolymerisierbaren Schicht.

3. Film nach Anspruch 2, wobei $R_1$ Alkyl mit 2 bis 14 Kohlenstoff-Atomen, Benzyl oder Cyclohexyl ist, und $R_2$ H oder gleich $R_1$ ist, oder $R_1$ und $R_2$ zusammen mit dem Stickstoff-Atom Pyridin oder Piperidin bilden.

4. Film nach Anspruch 2, wobei $R_1$ und $R_2$ jeweils Ethyl sind, oder $R_1$ Cyclohexyl und $R_2$ H ist.

5. Film nach Anspruch 3, wobei das Monomer ein Di-, Trioder Tetraacrylat oder -methacrylat und der Photoinitiator ein Hexaarylbiimidazol ist.

6. Film nach Anspruch 4, wobei die Bindemittel-Komponente im wesentlichen aus Polymethylmethacrylat und Polyvinylacetat besteht, die Monomer-Komponente im wesentlichen aus Trimethylolpropantrimethacrylat und ethoxyliertem Trimethylolpropantriacrylat besteht, und die Photoinitiator-Komponente im wesentlichen aus 2,2'-Bis-(o-chlorphenyl)-4,4',5,5'-tetraphenylbiimidazol und 2-Mercaptobenzoxazol besteht.

7. Film nach Anspruch 4, wobei Bindemittel-Komponente, Monomer-Komponente bzw. Photoinitiator-Komponente im wesentlichen bestehen aus: Methylmethacrylat/Ethylacrylat/Acrylsäure-Copolymeren; Trimethylolpropantrimethacrylat und Diacrylat-Estern von Bisphenol A/Epichlorhydrin-Epoxidharz; und 2,2'-Bis(o-chlorphenyl)-4,4',5,5'-tetraphenylbiimidazol und 2-Mercaptobenzoxazol.

8. Verfahren zur Herstellung eines aufgedruckten Farbtests, umfassend:

(a) Laminieren auf ein Farbtestpapier einen Photopolymer-Film mit einer an einer photopolymerisierbaren Schicht haftenden Decklage, ohne Leukofarbstoff, umfassend Bindemittel, Monomer und Initiator;

(b) abbildweises Belichten der photopolymerisierbaren Schicht durch die Decklage und ein Farbauszugsdia mit ultravioletter Strahlung, um ein Abbild belichteter, polymerisierter Bereiche und unbelichteter Bereiche zu erzeugen;

(c) Entfernen der Decklage und Entwickeln des Abbilds durch Anwendung eines entsprechenden Toners;

(d) Entfernen überschüssigen Toners, Laminieren eines weiteren Stücks Film auf die getonte Schicht und Wiederholen der Schritte (b) -(c) mit einem anderen Farbauszugsdia und entsprechendem Farbtoner; und

(e) gegebenenfalls Wiederholen des Schrittes (d), bis die gewünschte Anzahl von Schichten aufgebaut ist;

dadurch gekennzeichnet, daß der Film dadurch gegen Vorbelichtung mit Weißlicht stabilisiert wird, daß in die photopolymerisierbare Schicht eine Weißlicht-stabilisierende wirksame Menge im Bereich von 0,005 bis 3,0 Gew.-% einer Hydroxylamin-Verbindung der Formel $R_1R_2NOH$ nach Anspruch 1 eingeschlossen ist.

9. Verfahren nach Anspruch 8 zur Herstellung eines positiven aufgedruckten Farbtests durch Verwenden eines Films, von dem sich die Decklage nach Schritt (b) entfernen läßt ohne die Photopolymer-Schicht zu beeinträchtigen, und durch Tonen der gesamten Photopolymer-Schicht in Schritt (c), wodurch der Toner selektiv an den unbelichteten Stellen haftet.

10. Verfahren nach Anspruch 9, wobei mehrere Abzüge auf einem einzigen Blatt Papier hergestellt werden.

11. Verfahren nach Anspruch 10, wobei die HydroxylaminVerbindung Diethylhydroxylamin, N-Cyclohexylhydroxylamin, N,N-Dibenzylhydroxylamin, N-Hydroxypyridin oder N-Hydroxypiperidin ist.

12. Verfahren nach Anspruch 10, wobei die Hydroxylamin-Verbindung N,N-Diethylhydroxylamin ist.

## Revendications

1. Un film d'épreuve en couleur à base de photopolymère comprenant une couche support et une couche photopolymérisable constituée essentiellement d'un liant polymère, d'un monomère insaturé éthyléniquement et d'un initiateur de photopolymérisation, caractérisé en ce que le film présente une stabilité améliorée à la lumière blanche grâce à la présence dans la couche photopolymérisable d'un dérivé d'hydroxylamine de formule $R_1R_2NOH$ et leurs sels d'acide, dans lesquels chacun des $R_1$ et $R_2$ peuvent être un atome d'hydrogène sous réserve que tous les deux ne peuvent pas représenter un atome d'hydrogène, un groupe alkyle à chaîne linéaire ou ramifiée renfermant de 2 à 14 atomes de carbone, un groupe cyclique alkyle renfermant de 5 à 14 atomes de carbone, un groupe aryle renfermant de 6 à 10 atomes de carbone, un groupe aralkyle dans lequel la moitié aryle renferme de 6 à 10 atomes de carbone, et la moitié alkyle renferme de 1 à 14 atomes de carbone, et un groupe alkaryle dans lequel la moitié aryle renferme de 6 à 10 atomes de carbone et la moitié alkyle renferme de 1 à 9 atomes de carbone, et $R_1$ et $R_2$, lorsqu'ils sont pris ensemble, peuvent, en même temps que l'atome d'azote, former un cycle hétérocyclique renfermant de 5 à 7 atomes de carbone.

2. Film en surimpression positive selon la revendication 1, composé d'une couche photopolymérisable intercalée entre une feuille de support et une feuille de protection dans lequel la couche de support est amovible après exposition par une image et polymérisation sans perturber la couche de photopolymère, la quantité de dérivé d'hydroxylamine étant comprise entre 0,05 et 0,5% en poids par rapport au poids de la couche photopolymérisable.

3. Film selon la revendication 2, caractérisé en ce que $R_1$ est un radical alkyle renfermant de 2 à 14 atomes de carbone, benzyle ou cyclohexyle et $R_2$ représente H ou est identique à $R_1$, ou $R_1$ et $R_2$ avec l'atome d'azote auquel ils sont liés forment la pyridine ou la pipéridine.

4. Film selon la revendication 2, caractérisé en ce que $R_1$ et $R_2$ représentent chacun un radical éthyle ou $R_1$ représente le cyclohexyle et $R_2$ représente H.

5. Film selon la revendication 3, caractérisé en ce que le monomère est un di-, tri- ou tétra-acrylate ou -méthacrylate et le photo-initiateur est un hexaarylbiimidazole.

6. Film selon la revendication 4, caractérisé en ce que le composant liant est essentiellement constitué de polyméthylméthacrylate et de polyvinylacétate, le composant monomère est essentiellement constitué de triméthylolpropane triméthacrylate et triméthylolpropane triacrylate éthoxylé, et le composant photo-initiateur est essentiellement constitué de 2,2'-bis(o-chlorophényl)-4,4',5,5'-tétraphénylbiimidazole et de 2-mercaptobenzoxazole.

7. Film selon la revendication 4, caractérisé en ce que les composants liants monomère et photo-initiateur sont respectivement constitués essentiellement de: copolymères méthylméthacrylate/éthylacrylate/acide acrylique; triméthylolpropane triméthacrylate et ester diacrylate de résine époxy bisphénol A/épichlorohydrine; et de 2,2'-bis(o-chlorophényl)-4,4',5,5'-tétraphénylbiimidazole et 2-mercaptobenzoxazole.

8. Un procédé de confection d'une épreuve en couleur en surimpression qui comprend les étapes suivantes:

(a) on stratifie sur un papier d'épreuve en couleur un film à base de photopolymère comprenant une feuille de protection adhérant à une couche photopolymérisable comprenant un liant, un monomère et un initiateur;

(b) on expose la couche photopolymérisable à une image en radiation ultraviolette à travers la feuille de protection et un transparent de séparation de couleur pour créer une image de zones exposées polymérisées et zone non exposées;

(c) on retire la feuille de protection et on développe l'image par application d'un toner de couleur correspondante;

(d) on élimine le toner en excès, on stratifie un autre morceau de film sur la couche ayant reçu le toner; et on répète les étapes (b)-(c) avec un transparent de séparation de couleur différent et un toner de couleur correspondante; et

(e) on répète éventuellement l'étape (d) jusqu'à ce que l'on ait constitué le nombre souhaité de couches, caractérisé en ce que le film est stabilisé contre une pré-exposition à la lumière blanche par inclusion dans la couche photopolymérisable d'une quantité efficace pour la stabilisation à la lumière blanche comprise entre 0,005% et 3,0% en poids d'un dérivé d'hydroxylamine répondant à la formule: $R_1R_2NOH$ selon la revendication 1.

9. Procédé selon la revendication 8 d'une préparation d'une épreuve de couleur en surimpression positive par l'utilisation d'un film dont on peut retirer la feuille de protection après l'étape (b) sans perturber la couche photopolymère et par dépôt de toner dans l'étape (c) sur la totalité de la couche photopolymère, ce toner adhérant sélectivement sur les zones non exposées.

10. Procédé selon la revendication 9, caractérisé en ce que de multiples épreuves sont préparées sur une feuille de papier unique.

11. Procédé selon la revendication 10, caractérisé en ce que le dérivé d'hydroxylamine est la diéthylhydroxylamine, la N-cyclohexylhydroxylamine, la N,N-dibenzylhydroxylamine, la N-hydroxypyridine ou la N-hydroxypipéridine.

12. Procédé selon la revendication 10, caractérisé en ce que le dérivé d'hydroxylamine est la N,N-diéthylhydroxylamine.